# EUROPÄISCHE PATENTSCHRIFT

(11) **EP 0 387 797 B1**
(45) Veröffentlichungstag und Bekanntmachung des Hinweises auf die Patenterteilung: **15.06.1994**
(21) Anmeldenummer: 90104733.2
(22) Anmeldetag: 13.03.1990
(51) Int. Cl.: H02H 9/04, H01L 27/02

(54) **Monolithisch integrierbare Transistorschaltung zum Begrenzen von positiver Überspannung**
Monolithic integrable transitor circuit for limiting a positive overvoltage
Circuit intégré monolithique à transistor pour limiter une surtension positive

(30) Priorität: 16.03.1989 EP 89104711
(43) Veröffentlichungstag der Anmeldung: 19.09.1990
(73) Patentinhaber: SIEMENS AKTIENGESELLSCHAFT, 80333 München (DE)
(72) Erfinder: Kriedt, Hans, Dipl.-Ing., D-8000 München 80 (DE); Zietemann, Heinz, Dipl.-Phys., D-8000 München 83 (DE)

(56) Entgegenhaltungen:
- DE-A- 3 301 800
- FR-A- 2 555 833
- US-A- 4 271 445
- US-A- 4 302 792
- IBM TECHNICAL DISCLOSURE BULLETIN Band 30, Nr. 8, Januar 1988, Seiten 389,390, Armonk, NY, USA; "Cascaded electrostatic discharge protection structure"

## Beschreibung

Die Erfindung betrifft eine monolithisch integrierbare Transistorschaltung zum Begrenzen vorübergehender positiver Hochspannungen auf einem elektrischen Leiter mit den Merkmalen:
(a) der Emitteranschluß eines pnp-Transistors ist mit dem elektrischen Leiter verbunden,
(b) der Kollektoranschluß des pnp-Transistors ist an ein Bezugspotential (Masse) geschaltet,
(c) der pnp-Transistor ist nur bei Überschreiten eines vorgegebenen, gegenüber dem Bezugspotential (Masse) positiven Potentialschwellwertes leitend,
(d) der Basisanschluß des pnp-Transistors ist über eine erste Kapazität an das Bezugspotential (Masse) geschaltet,
(e) der pnp-Transistor ist durch ein p-dotiertes, mit dem Bezugspotential beaufschlagtes Substrat, eine n-dotierte, auf dem Substrat angeordnete Epitaxiewanne und einen abgegrenzten, in der Epitaxiewanne eingebrachten und mit dem Leiter verbundenen p-dotierten Bereich realisiert,
(f) die erste Kapazität ist durch die Sperrschichtkapazität eines PN-Überganges realisiert.

Eine solche Transistorschaltung ist als Teil einer Schutzschaltung gegen elektrostatische Entladungen bekannt, die in der Veröffentlichung IBM Technical Disclosure Bulletin, Band 30, Nr. 8, Seiten 389 bis 390, Januar 1988 gezeigt ist. Zum ordnungsgemäßen Betrieb ist die Basis des pnp-Transistors an das positive Versorgungspotential angeschlossen. Beim Ausfall der Versorgungsspannung kann deshalb die Schutzfunktion gegen elektrostatische Entladungen beeinträgtigt werden. Wenn der zu schützende Leiter an einen Datenbus angeschlossen ist, der mehrere Bausteine miteinander verbindet, kann außerdem bei einem Versorgungsspannungsausfall die Signalübertragung zwischen den anderen Bausteinen gestört werden, da die Leitung über die Emitter-Basis-Diode des pnp-Transistors auf Bezugspotential geklemmt wird.

In der US-Patentschrift 4 271 445 ist eine Schutzschaltung gegen Überspannungen mit einer gate-gesteuerten Diode gezeigt. Das Gate der Diode ist über die Parallelschaltung aus einem Widerstand und einem Kondensator mit der Leitung und über die parasitäre Kapazität einer Zenerdiode mit Bezugspotential verbunden. Dabei ist nur die gate-gesteuerte Diode monolithisch integriert, die anderen Elemente sind diskrete Elemente, die in Außenbeschaltung mit der gate-gesteuerten Diode verbunden sind.

Aus der DE-OS 26 54 419 sind Schaltungsanordnungen zur Spannungsbegrenzung auf elektrischen Leitern bekannt, bei denen eine steuerbare Strecke einer Halbleiteranordnung, insbesondere die Kollektor-Emitter-Strecke eines Transistors zwischen dem zu schützenden Leiter und dem Bezugspotential angeordnet ist. Vom Steuereingang der Halbleiteranordnung sind Dioden-Ketten jeweils in Sperrichtung zum zu schützenden Leiter bzw. zum Bezugspotential geschaltet. Zum Schutz vor positiven Hochspannungen auf dem zu schützenden Leiter ist die entsprechenden Dioden-Kette in Durchlaßrichtung vom zu schützenden Leiter zum Steuereingang der Halbleiteranordnung geschaltet, wobei die Anzahl der Dioden die maximal zulässige Spannung bestimmt. Bei integrierten Schaltungen sind solche Dioden-Ketten jedoch aufgrund ihres großen Flächenbedarfes möglichst zu vermeiden. Außerdem läßt sich der Spannungswert, bei dem die Spannungsbegrenzung eintreten soll, nur ungenau vorgeben und die Impedanz, mit der eine solche Schaltung den zu schützenden Leiter belastet, ist relativ großen Streuungen unterworfen und begrenzt die verarbeitbare Signalfrequenz beträchtlich.

Aus der DE-OS 31 25 198, insbesondere Figur 3, ist eine Transistorschutzschaltung zum Schutz von elektrischen Leitern vor vorübergehenden positiven Hochspannungen bekannt, wobei der Emitter eines pnp-Transistors an den zu schützenden Leiter angeschlossen ist, der Kollektor dieses pnp-Transistors an das Bezugspotential geschaltet ist, der Basisanschluß dieses pnp-Transistors über eine Diode in Durchlaßrichtung an das Bezugspotential geschaltet ist und mit einer Bezugsvorspannung beaufschlagt ist. Wenn der zu schützende Leiter beispielsweise an einen Bus oder einen Port eines Datensystems angeschlossen ist, so kann es vorkommen, daß auf dem Leiter Signalspannungen und auch ESD-Impulse auftreten, obwohl eine zu schützende und die Transistor-Schutzschaltung enthaltende Halbleiterschaltung außer Betrieb ist. In diesem Fall ist jedoch eine solche, aus der DE-OS 31 25 198 bekannte Transistor-Schutzschaltung ebenfalls außer Betrieb, da keine Bezugsvorspannung vorhanden ist.

Zum Schutz elektrischer Leiter vor vorübergehenden negativen Hochspannungen hat sich der Einsatz von Substratdioden bewährt. Bessere Hochfrequenzeigenschaften weist eine aus der DE-OS 33 01 800 bekannte Schutzschaltung zum Schutz vor negativen Hochspannungen auf.

Aufgabe der Erfindung ist das Bereitstellen einer monolithisch integrierbaren Transistorschaltung zum Begrenzen vorübergehender positiver Hochspannungen auf einem elektrischen Leiter, die unabhängig vom Vorhandensein einer Versorgungsspannung funktioniert und flächengünstig realisierbar ist.

Diese Aufgabe wird erfindungsgemäß dadurch gelöst, daß
(g) der Basisanschluß des pnp-Transistors über die Parallelschaltung eines Widerstandes und einer zweiten Kapazität an den elektrischen Leiter geschaltet ist und
(h) die zweite Kapazität durch einen aus dem elektrischen Leiter, einer Isolationsschicht und der Epitaxiewanne gebildeten Kondensator realisiert ist.

Günstige Ausgestaltungsformen sind Gegenstand von Unteransprüchen.

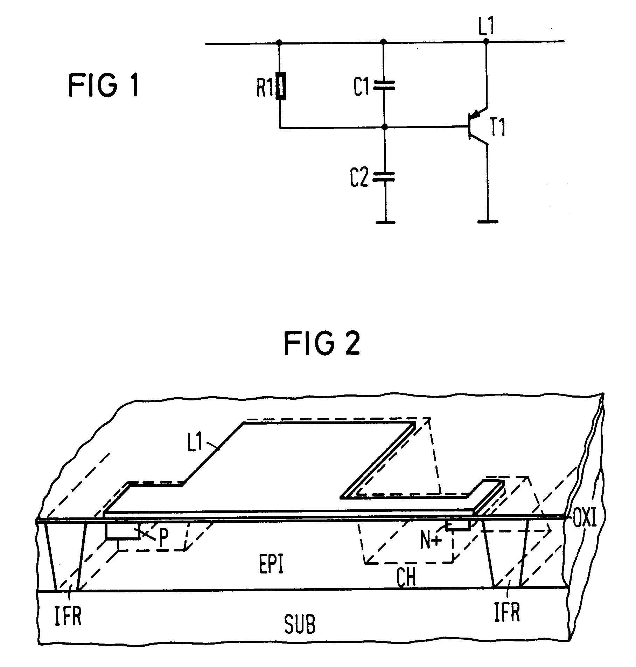

Aufbau und Funktionsweise einer erfindungsgemäßen monolithisch integrierbaren Transistorschaltung wird nachstehend anhand des in Figur 1 gezeigten Ausführungsbeispieles und anhand der in Figur 2 gezeigten Realisierungsform eines solchen Ausführungsbeispieles näher erläutert.

Es zeigt
- Figur 1: das Schaltbild einer erfindungsgemäßen Transistorschaltung;
- Figur 2: in perspektivischer Darstellung eine einfache Realisierungsmöglichkeit einer erfindungsgemäßen Transistorschaltung.

Figur 1 zeigt einen zu schützenden Leiter L1, der mit dem Emitter eines pnp-Transistors T1 sowie mit je einem Anschluß einer Kapazität C1 und eines, insbesondere hochohmigen Widerstandes R1 verbunden ist. Der jeweils andere Anschluß dieses Widerstandes R1 und dieser Kapazität C1 ist mit dem Basisanschluß des pnp-Transistors T1 zusammengeschaltet und über eine zweite Kapazität C2 an das Bezugspotential geschaltet. Der Kollektor eines pnp-Transistors T1 ist ebenfalls an das Bezugspotential angeschlossen. Ist der Leiter L1 mit einem üblichen Signal beaufschlagt, so wird ein mittlerer Spannungspegel dieses Signales über den hochohmigen Widerstand R1 an den Basisanschluß des pnp-Transistors Q1 gelegt. Die erste Kapazität C1 und die zweite Kapazität C2 bilden zwischen dem Leiter L1 und dem Bezugspotential Masse einen kapazitiven Spannungsteiler, wobei in Abhängigkeit vom Verhältnis ihrer beiden Kapazitätswerte eine schnelle Spannungsänderung auf dem Leiter L1 zu einer anteiligen Spannungsänderung am Basisanschluß des pnp-Transistors T1 führt. Wird ein positiver ESD-Impuls auf den Kontaktfleck gegeben, so verteilt sich die Spannung nach dem Kapazitätsverhältnis C1/C2. Fällt hierbei über die Kapazität C1 eine Spannung ab, die größer als die Schwellenspannung des pnp-Transistors T1 ist, so wird dieser pnp-Transistor T1 leitend und der Spannungspegel auf dem Leiter L1 somit begrenzt.

Der Widerstand R1 ist so zu wählen, daß ein sich gegebenenfalls einstellender Sperrstrom, der insbesondere durch den Kondensator C2, aber auch durch eine andere Halbleiterstruktur bedingt sein kann, so sicher ausgeräumt werden kann, daß der pnp-Transistor T1 im Normalbetrieb, d.h. ohne Vorliegen einer zu begrenzenden Hochspannung, nicht leitend wird.

Die unter anderem durch die Transistorschaltung zum Begrenzen vorübergehender positiver Hochspannungen verursachte parasitäre Kapazität, mit der der Leiter L1 belastet ist, sollte insbesondere, wenn hochfrequente Signale mit Hilfe dieses Leiters L1 übertragen werden sollen, möglichst konstant und möglichst klein gehalten werden. Bei entsprechender Wahl des Widerstandes R1 stellt dieser sicher, daß an der Basis des pnp-Transistors und somit an der zweiten Kapazität C2 gegen das Bezugspotential jeweils die am Leiter L1 vorgegebene Spannung anliegt. Falls die zweite Kapazität C2 in Form einer Sperrschichtskapazität realisiert ist, bringt ein Anstieg der Spannung auf dem Leiter L1 einen Anstieg der Sperrspannung und somit eine Verringerung der zweiten Kapazität C2 mit sich. In diesem Falle ist der Leiter L1 bei Vorliegen eines Signals, dessen Pegel gegenüber dem Bezugspotential positiv ist, kapazitiv geringer belastet, als ohne Signal. Die parasitäre kapazitive Belastung des Leiters L1 durch eine erfindungsgemäße Transistorschaltung zum Begrenzen vorübergehender positiver Hochspannung setzt sich im Normalbetrieb im wesentlichen aus der Parallelschaltung der Emitter-Kollektor-Kapazität des gesperrten pnp-Transistors T1 und einer kapazitiven Serienschaltung, gebildet aus der ersten Kapazität C1 und der zweiten Kapazität C2 zusammen. Änderungen der zweiten Kapazität C2 bringen also bei entsprechender Wahl der Kapazitätswerte keine allzu großen Schwankungen der parasitären kapazitiven Belastung des Leiters L1 mit sich.

Der Kehrwert der Zeitkonstanten, die aus der Parallelschaltung der Kapazitäten C1 und C2 sowie des Widerstandes R1 resultiert, sollte merklich unterhalb der auf dem Leiter L1 übertragenen Nutzfrequenz liegen. Für relativ schnell ansteigende Hochspannungssignale wie z.B. sogenannte Transienten bzw. EMD-Impulse ist die Zeitkonstante dieser Parallelschaltung nicht maßgeblich, da diese Änderungen bei entsprechender Wahl der Kapazitätswerte C1 und C2 über die als kapazitiven Spannungsteiler geschalteten Serienschaltung aus C1 und C2 an die Basis des pnp-Transistors T1 übertragen werden und den pnp-Transistor durchsteuern.

Üblicherweise sind elektrische Leiter wie z.B. Leiterbahnen oder Kontaktflecken bei monolithisch integrierten Schaltkreisen durch eine Isolationsschicht, beispielsweise eine Oxidschicht, eine Plasmanitridschicht oder eine Polyimidschicht von einer leitfähigen Halbleiterschicht getrennt. Eine solche Konfiguration stellt einen Plattenkondensator dar, dessen eine Elektrode die Leiterbahn bzw. der aufgrund seiner größeren Fläche zu einem größeren Kapazitätswert führende Kontaktfleck bildet, dessen andere Elektrode die darunterliegende Halbleiterschicht bildet und dessen Dielektrikum durch die Isolationsschicht realisiert wird.

Insbeondere unterhalb der Kontaktflecken von monolithisch integrierten Schaltungen werden üblicherweise Epitaxiewannen vorgesehen, weil unterhalb von Kontaktflecken, die nur durch eine Isolationsschicht vom Substrat getrennt sind, aufgrund der beim Kontaktieren entstehenden Wärme und des entstehenden Druckes Substratablösungen oder Rissen im Substrat auftreten können.

Wird zur Realisierung der ersten Kapazität C1 als Kondensator-Elektrode auf der Seite des zu schützenden Leiters L1 der Kontaktfleck vorgesehen und als zweite Kondensatorelektrode eine vom Kontaktfleck durch eine Isolationsschicht OXI getrennte, in ihrer seitlichen Ausdehnung durch einen aus hochdotiertem Halbleitermaterial oder Halbleiteroxid bestehenden Isolierrahmen IFR begrenzte, eine Wanne bildende Epitaxieschicht EPI vorgesehen, so läßt sich der Kapazitätswert des daraus resultierenden Kondensators in Abhängigkeit vom Material und der Dicke des Dielektrikums OXI und von der Größe der aktiven Fläche zwischen dem Kontaktfleck und der Epitaxiewanne gut einstellen.

Zur Realisierung des Widerstandes R1 kann unter Berücksichtigung der entsprechenden geometrischen Verhältnisse und der Dotierung ein dotiertes Halbleitermaterial verwendet werden, wie z.B. das eher schwach dotierte Halbleitermaterial einer Epitaxiewanne EPI. Um eine n-dotierte Epitaxiewanne EPI mit einem von dieser durch eine isolierende Schicht OXI getrennten Leiter zu kontaktieren und eventuell eine parasitäre Schottky-Diode zu vermeiden, ist es üblich, die isolierende Schicht OXI partiell zu unterbrechen und in dem dadurch gebildeten Kontaktbereich eine räumlich begrenzte höher dotierte Zone N+ vom gleichen Leitungstyp einzubringen. Zur leichteren Einstellung des Widerstandswertes kann die Epitaxieschicht EPI, die die unterhalb des Kontaktflecks angeordnete Epitaxiewanne bildet, in Form eines Kanals CH weitergeführt werden, wobei die Kontaktierungsstelle des zu schützenden Leiters L1 mit der Epitaxieschicht EPI möglichst weit von dieser Epitaxiewanne entfernt angeordnet ist und der Widerstandswert sich in Abhängigkeit vom spezifischen Widerstand der Epitaxieschicht EPI, vom Querschnitt des Kanales CH und von der Länge des Kanales CH bzw. der Lage der besagten Kontaktierungsstelle N+ zwischen dem Leiter L1 und der Epitaxieschicht EPI einstellen läßt.

Das Substrat SUB liegt bei Halbleiterschaltungen üblicherweise auf Bezugspotential. Somit ergibt sich bei einer auf einem p-Substrat aufgebrachten n-dotierten Epitaxiewanne EPI ein pn-Übergang vom Bezugspotential zur Epitaxieschicht EPI. Zwischen der Epitaxieschicht EPI und dem Substrat SUB existiert somit eine Sperrschicht mit ihrer, von der Sperrspannung abhängigen Sperrschichtkapazität. Außerdem bildet die Epitaxiewanne EPI mit dem sie seitlich abgrenzenden Isolierrahmen IFR eine Kapazität. Eine n-dotierte Epitaxiewanne EPI bildet folglich mit dem p-Substrat SUB und dem Isolierrahmen IFR eine Kapazität gegen das Bezugspotential, die als erfindungsgemäße zweite Kapazität C2 vorgesehen sein kann.

Figur 2 zeigt eine besonders günstige Realisierungsform einer erfindungsgemäßen Transistorschaltung.

Der Leiter L1, eine leitfähige Schicht, bildet einen Kontaktfleck mit relativ großer Fläche sowie schmälere Leiterbahnen. In der Figur 2 sind nur die für eine erfindungsgemäße Transistorschaltung erforderlichen Teile dargestellt. Der Leiter L1 ist durch eine isolierende Schicht OXI von einer insbesondere n-dotierten Epitaxieschicht EPI getrennt. Diese Epitaxieschicht EPI ist auf einem insbesondere p-dotierten Halbleitersubstrat SUB angeordnet und seitlich durch einen Isolierrahmen IFR isoliert. Die isolierende Schicht OXI ist an zwei Stellen unterbrochen, die nicht unmittelbar im Bereich des Kontaktflecks liegen und deshalb bei einem Bondvorgang nicht so sehr bezüglich Temperatur und Druck belastet werden. Im Bereich der einen Unterbrechung der isolierenden Schicht OXI ist ein abgegrenzter Bereich P vom gleichen Leitungstyp wie das Substrat SUB dotiert und derart angeordnet, daß er sowohl mit dem Leiter L1 als auch mit der Epitaxieschicht EPI kontaktiert ist. Dieser Bereich bildet den Emitter eines pnp-Transistors in einer erfindungsgemäßen Schaltung. Im Bereich der anderen Unterbrechung der isolierenden Schicht OXI, der am vom Kontaktfleck entgegengesetzten Ende eines von der Epitaxieschicht EPI gebildeten Kanales CH angeordnet ist, ist ein abgegrenzter Bereich N+ vom gleichen Leitungstyp wie die Epitaxieschicht EPI, aber erheblich höher als diese dotiert und derart angeordnet, daß er sowohl mit dem Leiter L1 als auch mit der Epitaxieschicht EPI kontaktiert ist. Dieser hoch dotierte Bereich sorgt für einen guten und definierten Kontakt zwischen der Epitaxieschicht EPI und dem Leiter L1. Wie bereits beschrieben, bildet der Leiter L1 mit der isolierenden Schicht OXI als Dielektrikum und der Epitaxieschicht EPI die erste Kapazität C1 einer erfindungsgemäßen Schaltung. Der abgegrenzte Bereich P bildet mit dem Substrat SUB und der Epitaxieschicht EPI den pnp-Transistor T1. Die Epitaxieschicht, besonders in dem seitlich begrenzten Kanal CH, bildet den Widerstand R1 und die Sperrschichtkapazität zwischen der Epitaxieschicht EPI und dem Substrat SUB bzw. dem Isolierrahmen IFR dient zur Realisierung der zweiten Kapazität C2.

Besonders günstig an dieser Art der Realisierung einer erfindungsgemäßen Transistorschaltung ist, daß kaum zusätzliche Chipfläche benötigt wird und daß sich die Kapazitätswerte und Widerstandswerte mit der erforderlichen Genauigkeit einstellen lassen.

## Patentansprüche

1. Monolithisch integrierbare Transistorschaltung zum Begrenzen vorübergehender positiver Hochspannungen auf einem elektrischen Leiter (L1) mit den Merkmalen:
(a) der Emitteranschluß eines pnp-Transistors (T1) ist mit dem elektrischen Leiter (L1) verbunden,
(b) der Kollektoranschluß des pnp-Transistors (T1) ist an ein Bezugspotential (Masse) geschaltet,
(c) der pnp-Transistor (T1) ist nur bei Überschreiten eines vorgegebenen, gegenüber dem Bezugspotential (Masse) positiven Potentialschwellwertes leitend,
(d) der Basisanschluß des pnp-Transistors (T1) ist über eine erste Kapazität (C2) an das Bezugspotential (Masse) geschaltet,
(e) der pnp-Transistor (T1) ist durch ein p-dotiertes, mit dem Bezugspotential beaufschlagtes Substrat (SUB), eine n-dotierte, auf dem Substrat (SUB) angeordnete Epitaxiewanne (EPI) und einen abgegrenzten, in der Epitaxiewanne (EPI) eingebrachten und mit dem Leiter (L1) verbundenen p-dotierten Bereich (P) realisiert,
(f) die erste Kapazität (C2) ist durch die Sperrschichtkapazität eines PN-Überganges realisiert,
**dadurch gekennzeichnet,**
(g) daß der Basisanschluß des pnp-Transistors (T1) über die Parallelschaltung eines Widerstandes (R1) und einer zweiten Kapazität (C1) an den elektrischen Leiter (L1) geschaltet ist und
(h) die zweite Kapazität (C1) durch einen aus dem elektrischen Leiter (L1), einer Isolationsschicht (OXI) und der Epitaxiewanne (EPI) gebildeten Kondensator realisiert ist.

2. Transistorschaltung nach Anspruch 1,
**dadurch gekennzeichnet,**
daß als Widerstandsmaterial zur Realisierung des Widerstandes (R1) eine Epitaxieschicht (EPI) vorgesehen ist.

3. Transistorschaltung nach Anspruch 2,
**dadurch gekennzeichnet,**
daß der Leiter (L1) die Epitaxieschicht (EPI) an einer in ihrer Flächenausdehnung begrenzten Stelle (N+) kontaktiert, daß diese Kontaktierungsstelle (N+) einen gewissen Abstand zum als Basis des vertikalen pnp-Transistors (T1) wirksamen Bereich der Epitaxiewanne (EPI) aufweist und die Epitaxiewanne (EPI) zwischen der Kontaktierungsstelle (N+) und dem als Basis des vertikalen pnp-Transistors wirksamen Bereiches der Epitaxiewanne (EPI) den Widerstand (R1) bildet.

## Claims

1. Monolithically integrable transistor circuit for limiting transient positive high voltages on an electrical conductor (L1) having the following features:
(a) the emitter terminal of a p-n-p transistor (T1) is connected to the electrical conductor (L1),
(b) the collector terminal of the p-n-p transistor (T1) is connected to a reference potential (earth),
(c) the p-n-p transistor (T1) only conducts if a predetermined potential threshold value which is positive with respect to the reference potential (earth) is exceeded,
(d) the base terminal of the p-n-p transistor (T1) is connected to the reference potential (earth) via a first capacitor (C2),
(e) the p-n-p transistor (T1) is provided by a p-doped substrate (SUB) which is at the reference potential, an n-doped epitaxial well (EPI) disposed on the substrate (SUB) and a separate p-doped region (P) introduced into the epitaxial well (EPI) and connected to the conductor (L1),
(f) the first capacitor (C2) is provided by the barrier-layer capacitance of a p-n junction,
characterized
(g) in that the base terminal of the p-n-p transistor (T1) is connected to the electrical conductor (L1) by means of the parallel connection of a resistor (R1) and a second capacitor (C1), and
(h) the second capacitor (C1) is provided by a capacitor formed by the electrical conductor (L1), an insulating layer (OXI) and the epitaxial well (EPI).

2. Transistor circuit according to Claim 1, characterized in that an epitaxial layer (EPI) is provided as resistance material to form the resistor (R1).

3. Transistor circuit according to Claim 2, characterized in that the conductor (L1) makes contact with the epitaxial layer (EPI) at a point (N+) which is limited in its areal extension and in that this contact point (N+) is at a certain distance from that region of the epitaxial well (EPI) which is active as the base of the vertical p-n-p transistor (T1) and the epitaxial well (EPI) forms the resistor (R1) between the contact point (N+) and that region of the epitaxial well (EPI) which is active as the base of the vertical p-n-p transistor.

## Revendications

1. Circuit à transistor intégrable monolithiquement pour limiter des hautes tensions positives transitoires sur un conducteur électrique (L1), aux particularités suivantes :
(a) la borne d'émetteur d'un transistor pnp (T1) est reliée au conducteur électrique (L1),
(b) la borne de collecteur du transistor pnp (T1) est reliée à un potentiel de référence (Masse),
(c) le transistor pnp (T1) ne conduit que lors du dépassement d'une valeur seuil de potentiel prédéterminée et positive par rapport au potentiel de référence (Masse),
(d) la borne de base du transistor pnp (T1) est reliée au potentiel de référence (Masse) par l'intermédiaire d'une première capacité (C2),
(e) le transistor pnp (T1) est réalisé par un substrat (SUB) dopé p et chargé par le potentiel de référence, par une cuvette épitaxiale (EPI) disposée sur le substrat (SUB) et dopée n, et par une zone (P) de limitation qui est dopée p, qui est déposée dans la cuvette épitaxiale (EPI) et qui est reliée au conducteur (L1),
(f) la première capacité (C2) est réalisée par la capacité de couches de blocage d'une jonction PN,
caractérisé en ce que
(g) la borne de base du transistor pnp (T1) est reliée au conducteur électrique (L1), par l'intermédiaire du circuit parallèle constitué d'une résistance (R1) et d'une deuxième capacité (C1) et
(h) la deuxième capacité (C1) est réalisée par un condensateur formé à partir du conducteur électrique (L1), d'une couche isolante (OXI) et de la cuvette épitaxiale (EPI).

2. Circuit à transistor suivant la revendication 1, caractérisé en ce
qu'il est prévu une couche épitaxiale (EPI), en tant que matériau de résistance pour la réalisation de la résistance (R1).

3. Circuit à transistor suivant la revendication 2, caractérisé en ce
que le conducteur (L1) met en contact la couche épitaxiale (EPI) avec une borne (N+) limitée dans sa superficie, que cette borne de contact (N+) est à une certaine distance de la zone de la cuvette épitaxiale (EPI) agissant en tant que base du transistor pnp vertical (T1) et que la cuvette épitaxiale (EPI) qui est située entre la borne de mise en contact (N+) et la zone de la cuvette épitaxiale (EPI) agissant comme base du transistor pnp vertical, forme la résistance (R1).
